# EUROPÄISCHE PATENTSCHRIFT

(11) **EP 2 619 845 B1**
(45) Veröffentlichungstag und Bekanntmachung des Hinweises auf die Patenterteilung: **18.03.2020**
(21) Anmeldenummer: 11758415.1
(22) Anmeldetag: 10.08.2011
(51) Int. Cl.: H01M 10/48, H04Q 9/00, G01R 31/396, G01R 31/3835, H01M 10/0525

(54) **BATTERIESYSTEM ZUR MESSUNG VON BATTERIEMODULSPANNUNGEN**
BATTERY SYSTEM FOR MEASURING BATTERY MODULE VOLTAGES
SYSTÈME DE BATTERIE POUR LA MESURE DE TENSIONS DE MODULES DE BATTERIE

(30) Priorität: 20.09.2010 DE 102010041053
(43) Veröffentlichungstag der Anmeldung: 31.07.2013
(73) Patentinhaber: Robert Bosch GmbH, 70442 Stuttgart (DE); SAMSUNG SDI CO., LTD., Yongin-si, Gyeonggi-do 446-577 (KR)
(72) Erfinder: BUTZMANN, Stefan, 71717 Beilstein (DE); FINK, Holger, 70567 Stuttgart (DE)
(74) Vertreter: Bee, Joachim
(86) Internationale Anmeldenummer: PCT/EP2011/063729
(87) Internationale Veröffentlichungsnummer: WO 2012/038148

(56) Entgegenhaltungen:
- DE-A1-102007 029 156
- DE-A1-102009 016 259
- FR-A1- 2 890 175

## Beschreibung

Die vorliegende Erfindung betrifft ein Batteriesystem sowie ein Verfahren zum Überwachen eines Batteriesystems und ein Kraftfahrzeug mit dem erfindungsgemäßen Batteriesystem.

### Stand der Technik

Es zeichnet sich ab, dass in Zukunft sowohl für stationäre Anwendungen, beispielsweise bei Windkraftanlagen, als auch Fahrzeugen, beispielsweise in Hybrid- und Elektrofahrzeugen, vermehrt neue Batteriesysteme zum Einsatz kommen werden, an die sehr hohe Anforderungen bezüglich der Zuverlässigkeit gestellt werden.

Hintergrund für diese hohen Anforderungen ist, dass ein Ausfall des Batteriesystems zu einem Ausfall des Gesamtsystems führen kann. Beispielsweise hat bei einem Elektrofahrzeug ein Ausfall der Traktionsbatterie einen so genannten "Liegenbleiber" zur Folge. Außerdem kann der Ausfall einer Batterie zu einem sicherheitsrelevanten Problem führen. Bei Windkraftanlagen werden beispielsweise Batterien eingesetzt, um bei starkem Wind die Anlage durch eine Rotorblattverstellung vor unzulässigen Betriebszuständen zu schützen.

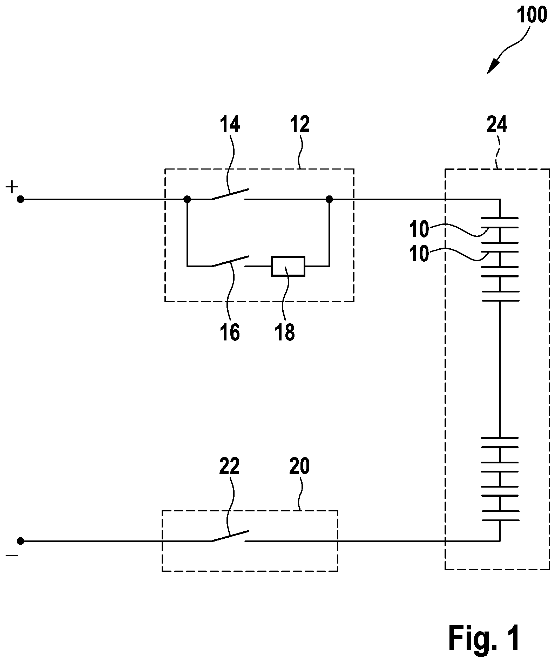

Das Prinzipschaltbild eines .Batteriesystems gemäß Stand der Technik ist in Figur 1 dargestellt. Ein insgesamt mit 100 bezeichnetes Batteriesystem umfasst eine Vielzahl von Batteriezellen 10, die in einem Modul 24 zusammengefasst sind. Ferner ist eine Lade- und Trenneinrichtung 12, welche einen Trennschalter 14, einen Ladeschalter 16 und einen Ladewiderstand 18 umfasst, vorgesehen.

Zusätzlich kann das Batteriesystem 100 eine Trenneinrichtung 20 mit einem Trennschalter 22 umfassen.

Für den sicheren Betrieb des Batteriesystems 100 ist es zwingend notwendig, dass jede Batteriezelle 10 innerhalb eines erlaubten Betriebsbereichs (Spannungsbereich, Temperaturbereich, Stromgrenzen) betrieben wird. Liegt eine Batteriezelle 10 außerhalb dieser Grenzen, muss sie aus dem Zellverbund herausgenommen werden. Bei einer Serienschaltung der Batteriezellen 10 (wie in Figur 1 dargestellt) führt daher ein Ausfall einer einzelnen Batteriezelle 10 zum Ausfall des gesamten Batteriesystems 100.

Insbesondere in Hybrid- und Elektrofahrzeugen werden Batterien in Lithium-Ionen- oder Nickel-Metall-Hybrid-Technologie eingesetzt, die eine große Anzahl in Serie geschalteter elektrochemischer Batteriezellen aufweisen. Eine Batteriemanagementeinheit wird zur Überwachung der Batterie eingesetzt und soll neben einer Sicherheitsüberwachung eine möglichst hohe Lebensdauer gewährleisten. So wird beispielsweise eine Zellspannungserfassungseinheit eingesetzt.

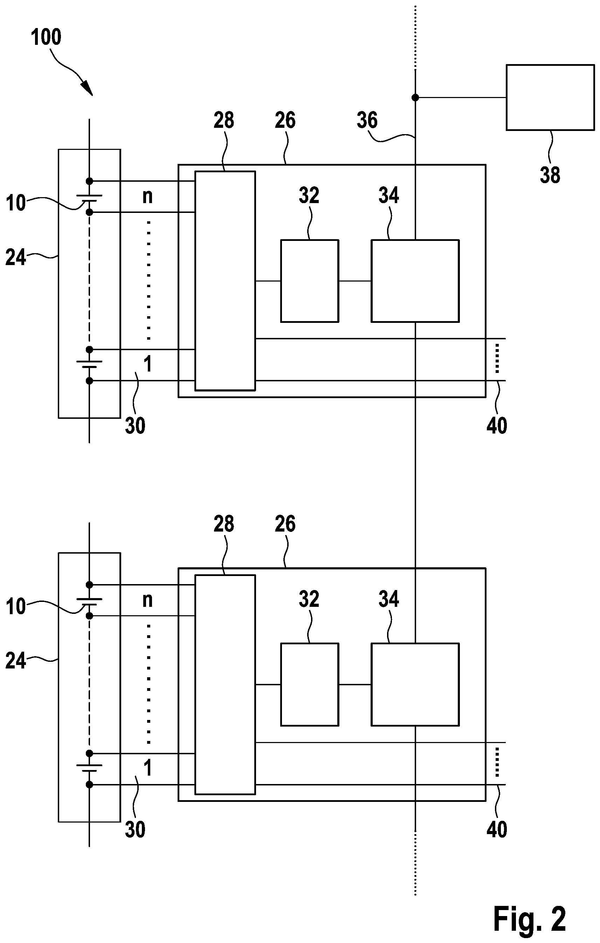

Figur 2 zeigt den bekannten Einsatz einer derartigen Zellspannungserfassungseinheit.

In Figur 2 ist eine aus dem Stand der Technik bekannte Architektur einer typischen Zellspannungserfassung gezeigt. Hierbei ist jedem Modul 24 mit seinen Batteriezellen 10 eine Zellspannungserfassungseinheit 26 zugeordnet. Die Zellspannungserfassungseinheit 26 umfasst einen Multiplexer 28, der über eine Anzahl der Batteriezellen 10 entsprechenden Anzahl von Kanälen 30 die Spannung jeder der einzelnen Batteriezellen 10 erfasst. Der Multiplexer 28 ist über einen Analog-Digital-Wandler 32 mit einem Gateway 34 verbunden, der an einem Kommunikationsbus 36 gekoppelt ist. An den Kommunikationsbus 36 ist ein zentraler Mikrocontroller 38 angeschlossen. Über diesen zentralen Mikrocontroller 38 können somit die Spannungen der einzelnen Batteriezellen 10 erfasst und ausgewertet werden. Der Mikrocontroller 38 kann Bestandteil einer Batteriemanagementeinheit sein.

Wie Figur 2 verdeutlicht, können hier mehrere Module 24 mit Batteriezellen 10 in Serie angeordnet sein, die jeweils über eine eigene Zellspannungserfassungseinheit 26 verfügen.
Der Multiplexer 28 besitzt hier angedeutete Hilfseingänge 40, die bekanntermaßen für eine Temperaturmessung dienen können, indem eine Erfassung von Widerstandswerten von NTC-Widerständen erfolgen kann.

Die DE 10 2007 029 156 A1 offenbart eine Überwachungsschaltung für eine Niederspannungsquelle mit Batterien in Reihenschaltung, sowie eine Verfahren zur Überwachen eines Niederspannungsabschnitts eines elektrischen Antriebs mittels einer galvanisch getrennten Kleinspannungssteuereinheit.

### Offenbarung der Erfindung

Erfindungsgemäß wird ein Batteriesystem mit wenigstens einem Modul, das eine Vielzahl von Batteriezellen umfasst, zur Verfügung gestellt, wobei jedem Modul eine Zellspannungserfassungseinheit zugeordnet ist, die über einen Kommunikationsbus mit einer Auswerteeinheit verbunden ist, wobei jedes Modul zusätzlich eine Modulspannungserfassungsschaltung umfasst, die mit der Auswerteinheit verbunden ist. Hierdurch werden erfindungsgemäß die über die Zellspannungserfassungseinheit gemessenen Zellspannungen verifiziert, indem die Spannungen der einzelnen Module zusätzlich separat gemessen und gesondert zu der Auswerteeinheit übertragen werden. Gemäß der Erfindung vergleicht die Auswerteeinheit die über die Zellspannungserfassungseinheit ermittelten und über den Kommunikationsbus digitalisiert übertragenen Zellspannungen mit den zusätzlichen Informationen, die über die Modulspannungserfassungseinheit bereitgestellt werden. Insbesondere kann so auch eine Plausibilität der über die Zellspannungserfassungseinheit gelieferten Zellspannungsinformationen festgestellt bzw. beurteilt werden.
In bevorzugter Ausgestaltung der Erfindung ist vorgesehen, dass die Modulspannungserfassungseinheit einen spannungsabhängigen Frequenzgenerator umfasst, der vorzugsweise ein Oszillator ist. Hierdurch wird in besonders einfacher Weise möglich, eine Gesamtmodulspannung zu erfassen und diese aufbereitet der Auswerteeinheit zur Verfügung zu stellen. Diese kann somit in einfacher Weise den erhaltenen Frequenzwert, der der gemessenen Modulspannung entspricht, einlesen und mit den von der Zellspannungserfassungseinheit erhaltenen Signalen vergleichen.

Ferner ist in bevorzugter Ausgestaltung der Erfindung vorgesehen, dass der Oszillator kapazitiv an die Auswerteeinheit gekoppelt ist. Hierdurch wird vorteilhaft möglich, den Effekt auszunutzen, dass eine kapazitive Kopplung mit wachsender Frequenz zunimmt. Hierdurch kann die Auswertung in einfacher Weise unterstützt werden. Ferner ist die Beeinflussung von Störspannungen auf die Auswerteeinheit über die Modulspannungserfassungsschaltung nicht möglich.
Erfindungsgemäß wird ferner ein Verfahren zur Überwachung eines Batteriesystems mit wenigstens einem Modul mit einer Vielzahl von Batteriezellen bereitgestellt, bei dem eine Spannung jeder der Batteriezellen erfasst und über eine Zellspannungserfassungseinheit einer Auswerteeinheit zugeführt wird, wobei zusätzlich eine Modulspannung separat erfasst und der Auswerteeinheit ebenfalls zugeführt wird. Hierdurch lässt sich in einfacher Weise die von der Zellspannungserfassungseinheit bereitgestellte Information verifizieren. Gemäß der Erfindung vergleicht die Auswerteeinheit die über die Zellspannungseinheit gemessenen Zellspannungen mit den über die Modulspannungserfassungseinheit bereitgestellten Modulspannungen. Durch die separate zusätzliche Erfassung der Modulspannungen steht der Auswerteeinrichtung eine weitere Möglichkeit, die Zuverlässigkeit des Batteriesystems insgesamt zu gewährleisten, zur Verfügung.
Bevorzugt ist vorgesehen, dass ein der Modulspannung proportionales Frequenzsignal generiert wird und dieses der Auswerteeinheit zugeführt wird. Hierdurch wird in einfacher Weise eine Kopplung des analogen gemessenen Modulspannungssignals mit der digital arbeitenden Auswerteeinheit möglich. Das Frequenzsignal kann als binäres Signal in einfacher Weise ausgewertet werden.
Ein weiterer Aspekt der Erfindung betrifft ein Kraftfahrzeug, welches das erfindungsgemäße Batteriesystem umfasst.
Insgesamt kann durch das erfindungsgemäße Batteriesystem bzw. das erfindungsgemäße Verfahren erreicht werden, dass die Zuverlässigkeit des Batteriesystems überprüft werden kann und eventuelle Fehlfunktionen rechtzeitig erkannt werden, um Folgeschäden durch unzuverlässig arbeitende Batteriesysteme zu vermeiden.

### Zeichnungen

Ausführungsbeispiele der Erfindung werden anhand der Zeichnungen und der nachfolgenden Beschreibung näher erläutert. Es zeigen:
Figur 1 ein Batteriesystem nach dem Stand der Technik,
Figur 2 eine Architektur einer Zellspannungserfassungseinheit nach dem Stand der Technik, und
Figur 3 ein erfindungsgemäßes Batteriesystem mit zusätzlicher Batteriemodulspannungsmessung.

### Ausführungsformen der Erfindung

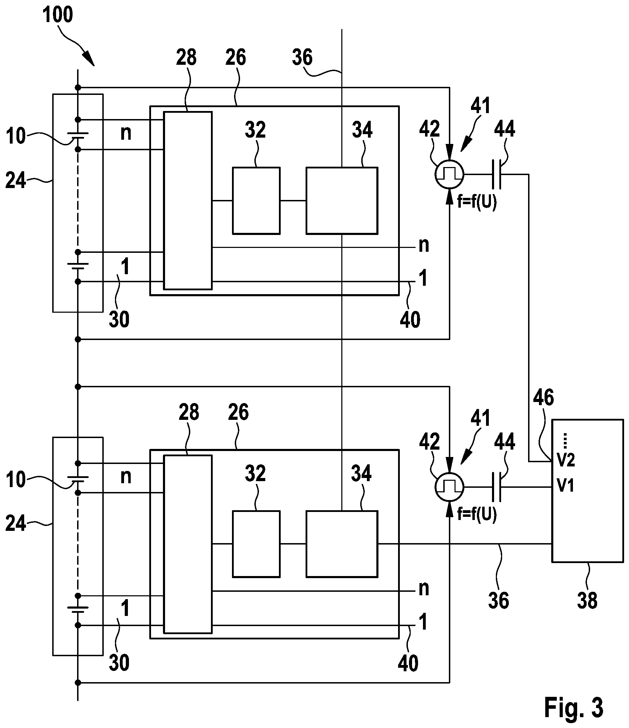

Figur 3 zeigt ein Batteriesystem 100 gemäß der Erfindung. Eine Vielzahl von Batteriezellen 10 sind in Reihe geschaltet und in einem Modul 24 zusammengefasst. In einem Multiplexer 28 werden die Zellspannungen der einzelnen Batteriezellen 10 zusammengeführt und über einen Analog-Digital-Wandler 32 sowie ein Gateway 34 in einen Kommunikationsbus 36 eingespeist. Über den Mikrocontroller 38 erfolgt die Spannungsauswertung in an sich bekannter Art und Weise.

In Figur 3 sind beispielhaft zwei Module 24 mit jeweils einer Vielzahl von Batteriezellen 10 dargestellt. Nach weiteren, nicht dargestellten Ausführungsbeispielen können auch mehrere der Module 24 in Reihe oder parallel zueinander verschaltet sein.

Jedem Modul 24 ist eine Modulspannungserfassungsschaltung 41 zugeordnet. Die Modulspannungserfassungsschaltung 41 greift die über das Modul 24 anliegende Spannung ab und führt diese einem Oszillator 42 zu. Der Oszillator 42 ist jeweils über eine Kondensatorschaltung 44 kapazitiv an Eingänge 46 der Auswerteschaltung 38 gekoppelt.

Mittels der Modulspannungserfassungsschaltung 41 wird die Spannung über das gesamte Modul 24 abgegriffen und in ein frequenzproportionales Signal umgewandelt. Dieses wird dann über die kapazitive Kopplung 44 der Auswerteschaltung 38 zur Verfügung gestellt. Die Auswerteschaltung 38 erhält gleichzeitig über den Kommunikationsbus 36 die Information von den Zellspannungserfassungseinheiten 26. Über eine entsprechende Zuordnung und Vergleich der Signale, die über den Kommunikationsbus 36 und die Eingänge 46 zur Verfügung gestellt werden, kann ein Vergleich und eine entsprechende Auswertung stattfinden. Hierbei wird die Modulspannung anhand der über den Oszillator 42 gemessenen Frequenz errechnet und mit dem über die Zellspannungserfassungseinheiten 26 gemessenen Zellspannungen verglichen.

## Patentansprüche

1. Batteriesystem (100) mit wenigstens zwei Modulen (24), die jeweils eine Vielzahl von Batteriezellen (10) umfassen, wobei jedem Modul (24) eine Zellspannungserfassungseinheit (26) zugeordnet ist, die über einen Kommunikationsbus (36) mit einer Auswerteeinheit (38) verbunden ist, und jedes Modul (24) zusätzlich eine Modulspannungserfassungsschaltung (41) umfasst, wobei jede Modulspannungserfassungsschaltung (41) gesondert von der entsprechenden Zellspannungserfassungseinheit (26) mit der Auswerteeinheit (38) verbunden ist, **dadurch gekennzeichnet, dass** die Auswerteeinheit (38) eingerichtet ist, über die Zellspannungserfassungseinheit (26) gemessene Zellspannungen zu verifizieren durch Vergleichen der Zellspannungen mit Modulspannungen, indem die Modulspannungen der einzelnen Module (24) zusätzlich separat gemessen und gesondert zu der Auswerteeinheit übertragen werden.

2. Batteriesystem (100) nach Anspruch 1, **dadurch gekennzeichnet, dass** die Modulspannungserfassungsschaltung (41) einen spannungsabhängigen Frequenzgenerator umfasst.

3. Batteriesystem nach Anspruch 2, **dadurch gekennzeichnet, dass** der Frequenzgenerator ein Oszillator (42) ist.

4. Batteriesystem nach Anspruch 3, **dadurch gekennzeichnet, dass** der Oszillator (42) kapazitiv an die Auswerteeinheit (38) gekoppelt ist.

5. Verfahren zum Überwachen eines Batteriesystems (100) mit mindestens zwei Modulen (24) mit jeweils einer Vielzahl von Batteriezellen (10), wobei eine Spannung jeder der Batteriezellen (10) erfasst und über eine Zellspannungserfassungseinheit (26) einer Auswerteeinheit (38) zugeführt wird, und zusätzlich eine Modulspannung für jedes Modul separat erfasst wird, wobei die jeweils separat erfasste Modulspannung über eine von der Zellspannungserfassungseinheit (26) gesondert mit der Auswerteeinheit (38) verbundene jeweilige Modulspannungserfassungsschaltung (41) der Auswerteeinheit (38) zugeführt wird, **dadurch gekennzeichnet, dass** durch die Auswerteeinheit (38) die über die Zellspannungserfassungseinheit gemessenen Zellspannungen verifiziert werden durch Vergleich mit den über die Modulspannungserfassungseinheit bereitgestellten Modulspannungen.

6. Verfahren nach Anspruch 5, **dadurch gekennzeichnet, dass** ein der Modulspannung proportionales Frequenzsignal generiert wird und dieses der Auswerteeinheit (38) zugeführt wird.

7. Kraftfahrzeug mit einem Batteriesystem (100) nach einem der vorhergehenden Ansprüche, wobei das Batteriesystem (100) mit einem Antriebssystem des Kraftfahrzeugs verbunden ist.

## Claims

1. Battery system (100) having at least two modules (24) which in each case comprise a multiplicity of battery cells (10), wherein each module (24) has an associated cell voltage sensing unit (26) which is connected to an evaluation unit (38) by means of a communication bus (36),and
each module (24) additionally comprises a module voltage sensing circuit (41), wherein each module voltage sensing circuit (41), separately from the corresponding cell voltage sensing unit (26), is connected to the evaluation unit (38), **characterized in that** the evaluation unit (38) is configured to verify cell voltages measured using the cell voltage sensing unit (26) by comparing the cell voltages with module voltages by virtue of the module voltages of the individual modules (24) additionally being separately measured and transmitted to the evaluation unit separately.

2. Battery system (100) according to Claim 1, **characterized in that** the module voltage sensing circuit (41) comprises a voltage-dependent frequency generator.

3. Battery system according to Claim 2, **characterized in that** the frequency generator is an oscillator (42).

4. Battery system according to Claim 3, **characterized in that** the oscillator (42) is capacitively coupled to the evaluation unit (38).

5. Method for monitoring a battery system (100) having at least two modules (24) having in each case a multiplicity of battery cells (10), wherein a voltage of each of the battery cells (10) is sensed and is supplied to an evaluation unit (38) via a cell voltage sensing unit (26), and additionally a module voltage for each module is separately sensed, wherein the in each case separately sensed module voltage is supplied to the evaluation unit (38) via a respective module voltage sensing circuit (41) connected to the evaluation unit (38) separately from the cell voltage sensing unit (26), **characterized in that** the evaluation unit (38) verifies the cell voltages measured using the cell voltage sensing unit by comparing them with the module voltages provided via the module voltage sensing unit.

6. Method according to Claim 5, **characterized in that** a frequency signal that is proportional to the module voltage is generated and this frequency signal is supplied to the evaluation unit (38).

7. Motor vehicle having a battery system (100) according to one of the preceding claims, wherein the battery system (100) is connected to a drive system of the motor vehicle.

## Revendications

1. Système de .batterie (100) comprenant au moins deux modules (24) qui comportent chacun une pluralité d'éléments de batterie (10), dans lequel, à chaque module (24) est associée une unité de détection de tension d'élément (26) qui est reliée à une unité d'évaluation (38) par l'intermédiaire d'un bus de communication (36), et chaque module (24) comprend en outre un circuit de détection de tension de module (41), dans lequel chaque circuit de détection de tension de module (41) est relié à l'unité d'évaluation (38) séparément de l'unité de détection de tension d'élément (26) correspondante, **caractérisé en ce que** l'unité d'évaluation (38) est conçue pour vérifier des tensions d'élément mesurées par l'intermédiaire de l'unité de détection de tension d'élément (26) par comparaison des tensions d'élément à des tensions de module, en faisant en sorte que les tensions de module des différents modules (24) soient en outre mesurées séparément et transmises séparément à l'unité d'évaluation.

2. Système de batterie (100) selon la revendication 1, **caractérisé en ce que** le circuit de détection de tension de module (41) comprend un générateur de fréquence dépendant de la tension.

3. Système de batterie selon la revendication 2, **caractérisé en ce que** le générateur de fréquence est un oscillateur (42).

4. Système de batterie selon la revendication 3, **caractérisé en ce que** l'oscillateur (42) est couplé de manière capacitive à l'unité d'évaluation (38).

5. Procédé de surveillance d'un système de batterie (100) comprenant au moins deux modules (24) qui comportent chacun une pluralité d'éléments de batterie (10), dans lequel une tension de chacun des éléments de batterie (10) est détectée et délivrée à une unité d'évaluation (38) par l'intermédiaire d'une unité de détection de tension d'élément (26), et une tension de module est en outre détectée séparément pour chaque module, dans lequel la tension de module détectée séparément est respectivement délivrée à l'unité d'évaluation (38) par l'intermédiaire d'un circuit de détection de tension de module (41) respectif relié séparément de l'unité de détection de tension d'élément (26) à l'unité d'évaluation (38), **caractérisé en ce que** les tensions d'élément mesurées par l'unité de détection de tension d'élément sont vérifiées par l'unité d'évaluation (38) par comparaison aux tensions de module fournies par l'intermédiaire de l'unité de détection de tension de module.

6. Procédé selon la revendication 5, **caractérisé en ce qu'**un signal de fréquence proportionnel à la tension de module est généré et **en ce qu'**il est délivré à l'unité d'évaluation (38).

7. Véhicule automobile comprenant un système de batterie (100) selon l'une des revendications précédentes, dans lequel le système de batterie (100) est relié à un système d'entraînement du véhicule automobile.
